# EUROPÄISCHE PATENTSCHRIFT

(11) **EP 4 016 007 B1**
(45) Veröffentlichungstag und Bekanntmachung des Hinweises auf die Patenterteilung: **20.03.2024**
(21) Anmeldenummer: 21205958.8
(22) Anmeldetag: 02.11.2021
(51) Int. Cl.: G01D 5/12, H01H 5/02, H03K 17/97

(54) **ELEKTRISCHES/ELEKTRONISCHES INSTALLATIONSGERÄT**
ELECTRIC/ELECTRONIC INSTALLATION DEVICE
APPAREIL D'INSTALLATION ELECTRIQUE/ELECTRONIQUE

(30) Priorität: 15.12.2020 DE 102020133491
(43) Veröffentlichungstag der Anmeldung: 22.06.2022
(73) Patentinhaber: Insta GmbH, 58509 Lüdenscheid (DE)
(72) Erfinder: Greve, Yannis, 58091 Hagen (DE); Becker-Hennecke, Ralph, 58239 Schwerte (DE)
(74) Vertreter: Fobbe, Tobias

(56) Entgegenhaltungen:
- EP-A1- 2 760 133
- DE-A1-102008 023 651
- DE-A1-102016 003 054

## Beschreibung

Die vorliegende Erfindung geht von einem gemäß Oberbegriff des Hauptanspruches konzipierten elektrischen/elektronischen Installationsgerät aus, welches ein Funktionsmodul aufweist, das mit einem Drehbedienelement versehen ist.

Derartige elektrische/elektronische Installationsgeräte sind typischerweise Geräte, die zur Dateneingabe und zur Datenausgabe vorgesehen sind und im Zusammenhang mit einem Installationssystem eines Gebäudes Verwendung finden. Oft ist ein als Einsatz ausgeführtes Funktionsmodul vorgesehen, welches häufig mehrere Bedienelemente aufweist. Oft ist zumindest eines dieser Bedienelement als Drehbedienelement ausgeführt. Der Einsatz beziehungsweise das Funktionsmodul eines solchen Installationsgerätes ist typischerweise so dimensioniert, dass dieser beziehungsweise dieses in eine handelsübliche Installationsdose eingesetzt werden kann. Die Bedienelemente eines solchen elektrischen/elektronischen Installationsgerätes sind in der Regel zum größten Teil der sichtseitigen Oberfläche zugeordnet und dazu vorgesehen, dieses elektrische/elektronische Installationsgerät zu bedienen und/oder mehrere weitere Geräte beziehungsweise Aktoren anzusteuern. In vielen Fällen weist die sichtseitige Oberfläche zur einfachen Kennzeichnung unterschiedliche Schaltflächen und/oder Piktogramme auf, damit sich dem Benutzer die Bedienung dieses Installationsgerätes auf einfache Art und Weise erschließt. Bei einem Drehbedienelement erfolgt die Funktionsauslösung in der Regel durch mechanische Verstellungen, zum Beispiel mittels der Finger eines Benutzers. Aus diesem Grunde ist eine eingängige haptische Rückmeldung für den Benutzer besonders wünschenswert.

Durch die DE 10 2013 001 367 A1 ist ein dem Oberbegriff des Hauptanspruches entsprechendes, ein als Einsatz ausgeführtes Funktionsmodul aufweisendes elektrisches/elektronisches Installationsgerät bekannt geworden. Ein solches elektrisches/elektronisches Installationsgerät ist zur Montage in einer in eine Gebäudewand eingebrachte Installationsdose vorgesehen und weist die zur Funktion notwendigen elektrischen/elektronischen Komponenten auf. Rückseitig ist ein solches elektrisches/elektronisches Installationsgerät mit Verbindungselementen zum Anschluss an ein Installationssystem eines Gebäudes versehen. Frontseitig weist dieses Koppelelemente zur Herstellung einer magnetischen Wirkverbindung mit einem Drehbedienelement auf, wobei im Einsatz mehrere sich ändernde Magnetfelder erfassende Sensoren untergebracht sind und wobei das Drehbedienelement zumindest einen Magneten aufweist, welcher mit den Sensoren des Einsatzes zusammenwirkt. Aus der DE 10 2016 003 054 A1 ist ein Bedienelement bekannt, welches Führungselemente bestückt mit jeweils einem Magnetelement aufweist.

Ausgehend von einem derart ausgebildeten elektrischen/elektronischen Installationsgerät liegt der vorliegenden Erfindung die Aufgabe zugrunde, auf besonders einfache Art und Weise ein elektrisches/elektronisches Installationsgerät zu schaffen, welches bei besonders einfachem und kompaktem Aufbau dem Benutzer eine Vielzahl von besonders intuitiv zu betätigenden Bedienmöglichkeiten bietet, um angeschlossene Aktoren bedarfsgerecht beeinflussen zu können.

Bei einer solchen Ausbildung ist besonders vorteilhaft, dass der Benutzer während der Betätigung des Bedienelementes eine besonders eingängige, feinfühlige haptische Rückmeldung erhält, ohne dass die Verwendung von Rastbahnen und damit zusammenwirkenden Rastfedern notwendig ist. Vorteilhafterweise ist die galvanisch getrennte Anordnung des zumindest einen, sich ändernde Magnetfelder erfassenden Sensors auf besonders einfache Art und Weise verwirklicht.

Weitere vorteilhafte Ausgestaltungen des erfindungsgemäßen Gegenstandes sind in den Unteransprüchen angegeben. Anhand von vier Ausführungsbeispielen sei die Erfindung im Prinzip näher erläutert. Dabei zeigen:
- Fig. 1:: prinziphaft eine Explosionsdarstellung eines elektrischen/elektronischen Installationsgerätes in Zuordnung einer Installationsdose gemäß erstem Ausführungsbeispiel;
- Fig. 2:: prinziphaft eine Explosionsdarstellung eines elektrischen/elektronischen Installationsgerätes in Zuordnung einer Installationsdose gemäß zweitem Ausführungsbeispiel;
- Fig. 3:: prinziphaft eine Explosionsdarstellung eines elektrischen/elektronischen Installationsgerätes in Zuordnung einer Installationsdose gemäß drittem Ausführungsbeispiel;
- Fig. 4:: prinziphaft eine Explosionsdarstellung eines elektrischen/elektronischen Installationsgerätes in Zuordnung einer Installationsdose gemäß viertem Ausführungsbeispiel.

Wie aus den Figuren hervorgeht, weist das elektrische/elektronische Installationsgerät ein als Einsatz E ausgeführtes Funktionsmodul auf, welches zur Montage in einer in eine Gebäudewand G eingebrachte Installationsdose I vorgesehen ist. Der Einsatz E weist mehrere zur Funktion notwendige elektrische/elektronische Komponenten K auf und ist rückseitig mit Verbindungselementen 8 zum Anschluss an ein Installationssystem eines Gebäudes versehen. Frontseitig weist der Einsatz E Koppelelemente zur Herstellung einer magnetischen Wirkverbindung mit zumindest einem Bedienelement 1 auf. Im Einsatz E ist zumindest ein sich ändernde Magnetfelder erfassender Sensor 2 untergebracht, welcher mit zumindest einem im Bedienelement 1 vorhandenen Magnetelement 9 zusammenwirkt. Der Einsatz E ist frontseitig mit einer rückseitig an der Gebäudewand G zur Anlage kommenden Abschlussplatte 4 versehen, wobei die Abschlussplatte 4 an ihrer dem Bedienelement 1 zugewandten Außenfläche zumindest ein als Führungsbahn 5 ausgeführtes Koppelelement aufweist. Die Führungsbahn 5 ist mit mehreren magnetischen Metallelementen 6 bestückt und das Bedienelement 1 weist eine mit der Führungsbahn 5 zusammenwirkende, als Führungsnut 7 ausgebildete Führungseinrichtung auf. Der Führungsnut 7 sind mehrere Magnetelemente 9 zugeordnet, die in ihrer Anzahl den magnetischen Metallelementen 6 der Führungsbahn 5 entsprechen und zur bedarfsgerechten Funktionsauslösung mit dem zumindest einen, sich ändernden Magnetfelder erfassenden Sensor 2 zusammenwirken. Zur Auswertung und Weiterverarbeitung steht der zumindest eine Sensor 2 mit den zur Funktion notwendigen elektrischen/elektronischen Komponenten K in Verbindung, welche zumindest einen Mikrocontroller und eine entsprechende elektronische Schaltung umfassen. Der Sensor 2 weist beziehungsweise die Sensoren 2 weisen eine galvanisch getrennte Anordnung auf.

Wie des Weiteren aus den Figuren hervorgeht, sind die magnetischen Metallelemente 6, gleichmäßig verteilt, über die Abmessung der Führungsbahn 5 beziehungsweise der Führungsbahnen 5 angeordnet und sind die Magnetelemente 9 der Führungsnut 7 beziehungsweise den Führungsnuten 7 gleichmäßig über dessen Abmessung verteilt zugeordnet. Bei den vier vorliegenden Ausführungsbeispielen weisen sowohl die Führungsbahnen 5 als auch die Führungsnuten 7 je eine kreisförmige Ausgestaltung auf. Zudem weisen alle magnetischen Metallelemente 6 eine zylinderartige Formgebung auf. Auch weisen die Magnetelemente 9 eine zylinderartige Formgebung auf. In jede der Führungsbahnen 5 sind mehrere erste Aufnahmetaschen für die Halterung der magnetischen Metallelemente 6 eingeformt, zudem sind, in Zuordnung zur Führungsnut 7 eines jeden Bedienelementes 1, mehrere zweite Aufnahmetaschen für die Halterung der Magnetelemente 9 eingeformt. Beispielsweise sind sechzehn magnetische Metallelemente 6 und sechzehn Magnetelemente 9 je Führungsbahn 5 und je Führungsnut 7 vorgesehen. Somit ist gewährleistet, dass der zugehörige Sensor 2 zur Beeinflussung von an das elektrische/elektronische Installationsgerät angeschlossenen Aktoren mit sich fein ändernden Magnetfeldern beaufschlagt wird und gleichzeitig durch das Zusammenwirken der magnetischen Metallelemente 6 und der Magnetelemente 9 dem Benutzer während der Betätigung des Bedienelementes 1 eine besonders eingängige, feinfühlige haptische Rückmeldung zu Teil wird.

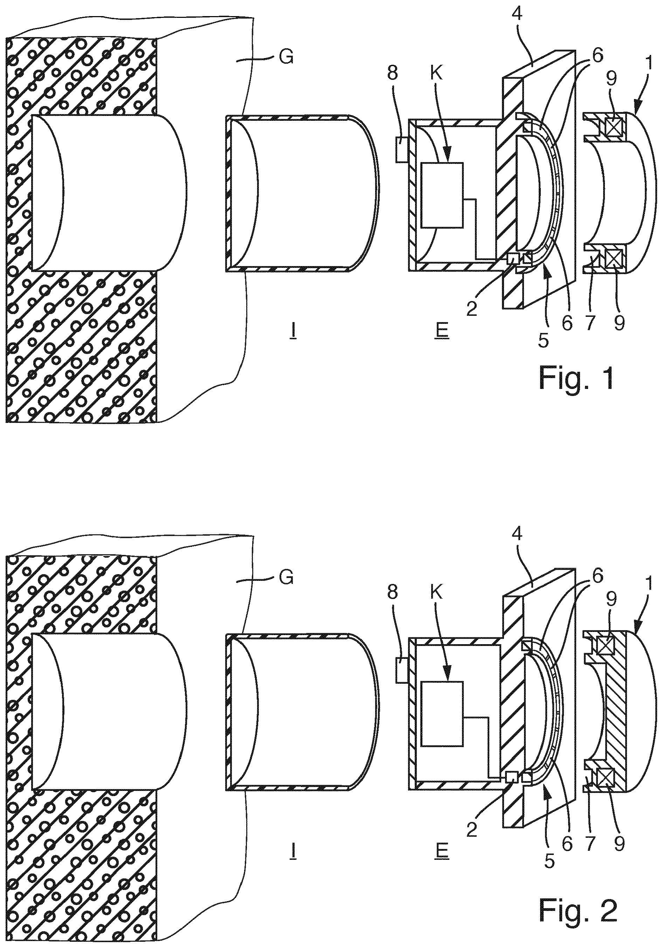

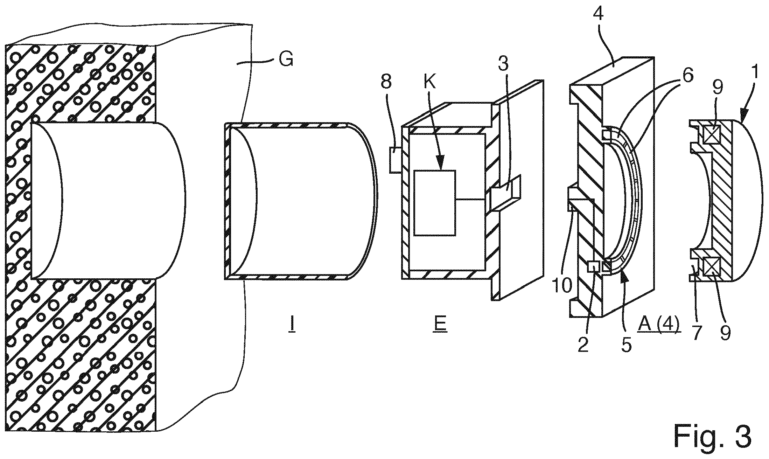

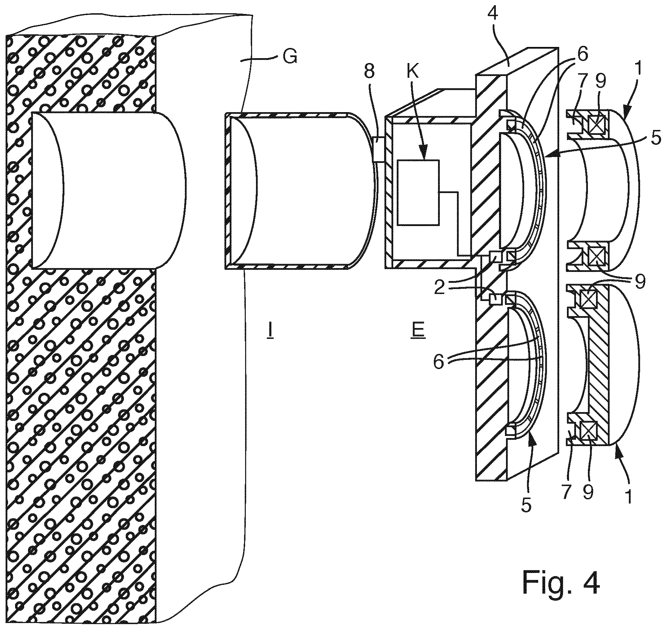

Wie des Weiteren aus den Figuren hervorgeht, ist jedes der Bedienelemente 1 gemäß der vorliegenden vier Ausführungsbeispiele manuell verdrehbar ausgeführt. Beim ersten Ausführungsbeispiel gemäß Figur 1 ist das Bedienelement 1 als Betätigungsring ausgeführt. Beim zweiten und dritten Ausführungsbeispiel gemäß Figur 2 und Figur 3 ist das Bedienelement 1 je als ein eine zylindrische Form aufweisender Betätigungsknopf ausgeführt. Beim vierten Ausführungsbeispiel gemäß Figur 4 sind zwei Bedienelemente 1 vorgesehen, wobei das erste der Bedienelemente 1 als Betätigungsring ausgeführt ist und wobei das zweite der Bedienelemente 1 als eine zylindrische Form aufweisender Betätigungsknopf ausgeführt ist. Die Bedienelemente können ohne Weiteres auch eine andere Formgebung aufweisen und/oder nicht nur verdrehbar sondern zum Beispiel auch verschiebbar, verschwenkbar und so weiter ausgeführt sein. Bei den vier vorliegenden Ausführungsbeispielen - nicht näher dargestellt aber durchaus vorsehbar - kann das Bedienelement und/oder die Abschlussplatte mit Funktionsbezeichnungen in Form von Piktogrammen versehen sein. Auch ist es möglich, um einen höheren Schutz vor dem Eindringen von Feuchtigkeit, Staub und so weiter zu gewährleisten, die Abschlussplatte an ihrer der Gebäudewand zugeordneten Rückseite mit einer an der Gebäudewand zur Anlage kommenden Dichtung zu versehen.

Wie insbesondere aus den Figuren 1 und 2 hervorgeht (erstes und zweites Ausführungsbeispiel), sind Gehäuse und Abschlussplatte 4 des Einsatzes E einstückig ausgeführt. Wie insbesondere aus der Figur 3 hervorgeht (drittes Ausführungsbeispiel), weist der Einsatz E frontseitig eine elektrische Steckerbuchse 3 auf und ist die Abschlussplatte 4 als separat händelbarer Aufsatz A ausgeführt. Zur mechanischen und elektrischen Kopplung weist der Aufsatz A (Abschlussplatte 4) einen elektrischen Stecker 10 auf, welcher mit der elektrischen Steckerbuchse 3 des Einsatzes E elektrisch und mechanisch zusammenwirkt. Wie insbesondere aus Figur 4 hervorgeht (viertes Ausführungsbeispiel), ist der Einsatz E mehrkanalig ausgeführt, dies bedeutet, im vorliegenden Fall, dass die Abschlussplatte 4 zwei, je als Führungsbahn 5 ausgeführte Koppelelemente aufweist, welche je mit einem Bedienelemente 1 zusammenwirkt. Je Bedienelement 1 ist zumindest ein Sensor 2 vorgesehen. Wie bereits erwähnt, ist das erste der beiden Bedienelemente 1 als Betätigungsring und ist das zweite der beiden Bedienelemente 1 als eine zylindrische Form aufweisender Betätigungsknopf ausgeführt.

Um eine besonders gute Erfassung der sich ändernden Magnetfelder für den Sensor 2 beziehungsweise die Sensoren 2 zu ermöglichen, ist der je einerseits mit den elektrischen/elektronischen Komponenten 8 in Verbindung stehende Sensor 2 andererseits derart in der Abschlussplatte 4 angeordnet, sodass dieser besonders nah an den magnetischen Metallelementen 6 der zugehörigen Führungsbahn 5 platziert ist.

Somit sind auf besonders einfache Art und Weise elektrische/elektronische Installationsgeräte geschaffen, welche bei besonders einfachem und kompaktem Aufbau dem Benutzer eine Vielzahl von besonders intuitiv zu betätigenden Bedienmöglichkeiten bietet, um angeschlossene Aktoren bedarfsgerecht beeinflussen zu können. Vorteilhafterweise erhält der Benutzer während der Betätigung des Bedienelementes 1 eine besonders eingängige, feinfühlige, haptische Rückmeldung, ohne dass die Verwendung von Rastbahnen und damit zusammenwirkenden Rastfedern notwendig ist. Die galvanische Trennung des zumindest einen Sensors 2 ist ebenfalls auf besonders einfache Art und Weise realisiert.

Durch die magnetische Wirkverbindung zwischen den magnetischen Metallelementen 6 und den Magnetelementen 9 ergibt sich für das Bedienelement 1 sowohl eine funktionsgerechte Halterung an der Abschlussplatte 4 als auch die zur Beeinflussung von angeschlossenen Aktoren notwendige Verdrehbarkeit. Zudem ist, wie bereits beschrieben, durch diese magnetische Wirkverbindung eine feinfühlige, haptische Rückmeldung für den Benutzer realisiert.

### Bezugszeichenliste

- 1: Bedienelement
- 2: Sensoren
- 3: Steckerbuchse
- 4: Abschlussplatte
- 5: Führungsbahn
- 6: Magnetische Metallelemente
- 7: Führungsnut
- 8: Verbindungselemente
- 9: Magnetelemente
- 10: Stecker

- A: Aufsatz
- G: Gebäudewand
- I: Installationsdose
- K: Elektrische/elektronische Komponenten

## Patentansprüche

1. Elektrisches/elektronisches Installationsgerät mit einem als Einsatz (E) ausgeführten Funktionsmodul, welches zur Montage in einer in eine Gebäudewand (G) eingebrachte Installationsdose (I) vorgesehen ist, und welches zur Funktion notwendige elektrische/elektronische Komponenten (K) aufweist und welches rückseitig mit Verbindungselementen (8) zum Anschluss an ein Installationssystem eines Gebäudes versehen ist sowie frontseitig Koppelelemente zur Herstellung einer magnetischen Wirkverbindung mit zumindest einem Bedienelement (1) aufweist, wobei im Einsatz (E) zumindest ein sich ändernde Magnetfelder erfassender Sensor (2) untergebracht ist und wobei das Bedienelement (1) zumindest ein Magnetelement (9) aufweist, welches mit dem zumindest einem galvanisch getrennt angeordneten Sensor (2) des Einsatzes (E) zusammenwirkt, wobei der Einsatz (E) frontseitig mit einer rückseitig an der Gebäudewand (G) zur Anlage kommenden Abschlussplatte (4) versehen ist, und wobei die Abschlussplatte (4) an ihrer dem zumindest einem Bedienelement (1) zugewandten Außenfläche zumindest ein als Führungsbahn (5) ausgeführtes Koppelelement aufweist, welche zumindest eine Führungsbahn (5) mit mehreren magnetischen Metallelementen (6) bestückt ist, und wobei das zumindest eine Bedienelement (1) zumindest eine mit der zumindest einen Führungsbahn (5) zusammenwirkende Führungseinrichtung aufweist, und wobei der zumindest einen Führungseinrichtung mehrere Magnetelemente (9) zugeordnet sind, die in ihrer Anzahl den magnetischen Metallelementen (6) der Führungsbahn (5) entsprechen.

2. Elektrisches/elektronisches Installationsgerät nach Anspruch 1, **dadurch gekennzeichnet, dass** zumindest eine Führungseinrichtung als Führungsnut (7) ausgeführt ist.

3. Elektrisches/elektronisches Installationsgerät nach einem der Ansprüche 1 oder 2, **dadurch gekennzeichnet, dass** die magnetischen Metallelemente (6) gleichmäßig verteilt über die Abmessung der Führungsbahn (5) angeordnet sind.

4. Elektrisches/elektronisches Installationsgerät nach einem der Ansprüche 1 bis 3, **dadurch gekennzeichnet, dass** die Magnetelemente (9) der zumindest einen Führungseinrichtung gleichmäßig über deren Abmessung verteilt zugeordnet sind.

5. Elektrisches/elektronisches Installationsgerät nach einem der Ansprüche 1 bis 4, **dadurch gekennzeichnet, dass** zumindest eines der magnetischen Metallelemente (6) eine zylinderartige Formgebung aufweist.

6. Elektrisches/elektronisches Installationsgerät nach einem der Ansprüche 1 bis 5, **dadurch gekennzeichnet, dass** zumindest eines der Magnetelemente (9) eine zylinderartige Formgebung aufweist.

7. Elektrisches/elektronisches Installationsgerät nach einem der Ansprüche 1 bis 6, **dadurch gekennzeichnet, dass** in der Führungsbahn (5) mehrere erste Aufnahmetaschen für die Halterung der magnetischen Metallelemente (6) eingeformt sind.

8. Elektrisches/elektronisches Installationsgerät nach einem der Ansprüche 1 bis 6, **dadurch gekennzeichnet, dass** in Zuordnung der zumindest einen Führungseinrichtung (Führungsnut 7) in das Bedienelement (1) mehrere zweite Aufnahmetaschen für die Halterung der Magnetelemente (9) eingeformt sind.

9. Elektrisches/elektronisches Installationsgerät nach einem der Ansprüche 1 bis 8, **dadurch gekennzeichnet, dass** zumindest ein Bedienelement (1) manuell verdrehbar ausgeführt ist.

10. Elektrisches/elektronisches Installationsgerät nach einem der Ansprüche 1 bis 9, **dadurch gekennzeichnet, dass** zumindest ein Bedienelement (1) manuell verschiebbar ausgeführt ist.

11. Elektrisches/elektronisches Installationsgerät nach einem der Ansprüche 1 bis 10, **dadurch gekennzeichnet, dass** zumindest ein Bedienelement (1) manuell verschwenkbar ausgeführt ist.

12. Elektrisches/elektronisches Installationsgerät nach einem der Ansprüche 1 bis 11, **dadurch gekennzeichnet, dass** zumindest ein Bedienelement (1) als Betätigungsring ausgeführt ist.

13. Elektrisches/elektronisches Installationsgerät nach einem der Ansprüche 1 bis 12, **dadurch gekennzeichnet, dass** zumindest ein Bedienelement (1) als ein eine zylindrische Form aufweisender Betätigungsknopf ausgeführt ist.

14. Elektrisches/elektronisches Installationsgerät nach einem der Ansprüche 1 bis 13, **dadurch gekennzeichnet, dass** zumindest ein Bedienelement (1) als zumindest drei Eckbereiche aufweisender Betätigungsknopf ausgeführt ist.

15. Elektrisches/elektronisches Installationsgerät nach einem der Ansprüche 1 bis 14, **dadurch gekennzeichnet, dass** zumindest ein Bedienelement (1) mit zumindest einer Funktionsbezeichnung versehen ist.

16. Elektrisches/elektronisches Installationsgerät nach einem der Ansprüche 1 bis 15, **dadurch gekennzeichnet, dass** die Abschlussplatte (4) an ihrer der Gebäudewand zugeordneten Rückseite mit einer an der Gebäudewand zur Anlage kommenden Dichtung versehen ist.

17. Elektrisches/elektronisches Installationsgerät nach einem der Ansprüche 1 bis 16, **dadurch gekennzeichnet, dass** der Einsatz (E) frontseitig eine elektrische Steckerbuchse (3) aufweist, und dass die Abschlussplatte als Aufsatz (A) ausgeführt ist und einen mit der elektrischen Steckerbuchse (3) zusammenwirkenden elektrischen Stecker (10) aufweist.

18. Elektrisches/elektronisches Installationsgerät nach einem der Ansprüche 1 bis 17, **dadurch gekennzeichnet, dass** der Einsatz (E) mehrkanalig ausgeführt ist, und dass die Abschlussplatte (4) mehrere als Führungsbahnen (5) ausgeführte Koppelelemente zum Zusammenwirken mit zumindest zwei Bedienelementen (1) aufweist.

## Claims

1. Electrical/electronic installation device with a functional module designed as an insert (E) being provided for mounting in an installation box (I) installed in a building wall (G), and having electrical/electronic components (K) necessary for functioning and being provided at the rear with connecting elements (8) for connection to an installation system of a building and at the front having coupling elements for producing a magnetic active connection with at least one operating element (1), wherein in the insert (E) is housed at least one sensor (2) detecting changing magnetic fields and wherein the operating element (1) has at least one magnetic element (9) which interacts with the at least one electrically isolated sensor (2) of the insert (E),
wherein the insert (E) is provided on the front side with an end plate (4) coming to rest on the rear side of the building wall (G), and
wherein the end plate (4), on its outer surface facing the at least one operating element (1), provides at least one coupling element designed as guideway (5), which at least one guideway (5) is fitted with a plurality of magnetic metal elements (6), and
wherein the at least one operating element (1) provides at least one guiding device interacting with the at least one guideway (5), and
wherein several magnetic elements (9) are assigned to the at least one guiding device, which magnetic elements (9) correspond in number to the magnetic metal elements (6) of the guideway (5).

2. Electrical/electronic installation device in accordance with Claim 1, **characterized in that** at least one guiding device is designed as lead groove (7).

3. Electrical/electronic installation device in accordance with any of Claims 1 or 2, **characterized in that** the magnetic metal elements (6) are arranged evenly distributed over the dimension of the guideway (5).

4. Electrical/electronic installation device in accordance with any of Claims 1 to 3, **characterized in that** the magnetic elements (9) of the at least one guiding device are assigned evenly distributed over its dimension.

5. Electrical/electronic installation device in accordance with any of Claims 1 to 4, **characterized in that** at least one of the magnetic metal elements (6) has a cylindric shape.

6. Electrical/electronic installation device in accordance with any of Claims 1 to 5, **characterized in that** at least one of the magnetic elements (9) has a cylindrical shape.

7. Electrical/electronic installation device in accordance with any of Claims 1 to 6, **characterized in that** a plurality of first receiving pockets for holding the magnetic metal elements (6) are formed in the guideway (5).

8. Electrical/electronic installation device in accordance with any of Claims 1 to 6, **characterized in that** in association with the at least one guiding device (lead groove 7) a plurality of second receiving pockets for holding the magnetic elements (9) are formed in the operating element (1).

9. Electrical/electronic installation device in accordance with any of Claims 1 to 8, **characterized in that** at least one operating element (1) is designed to be manually rotatable.

10. Electrical/electronic installation device in accordance with any of Claims 1 to 9, **characterized in that** at least one operating element (1) is designed to be manually displaceable.

11. Electrical/electronic installation device in accordance with any of Claims 1 to 10, **characterized in that** at least one operating element (1) is designed to be manually pivotable.

12. Electrical/electronic installation device in accordance with any of Claims 1 to 11, **characterized in that** at least one operating element (1) is designed as operating ring.

13. Electrical/electronic installation device in accordance with any of Claims 1 to 12, **characterized in that** at least one operating element (1) is designed as actuating knob having a cylindrical shape.

14. Electrical/electronic installation device in accordance with any of Claims 1 to 13, **characterized in that** at least one operating element (1) is designed as actuating knob having at least three corners.

15. Electrical/electronic installation device in accordance with any of Claims 1 to 14, **characterized in that** at least one operating element (1) is provided with at least one function description.

16. Electrical/electronic installation device in accordance with any of Claims 1 to 15, **characterized in that** the end plate (4), on its rear side facing the building wall, is provided with a seal coming into contact with the building wall.

17. Electrical/electronic installation device in accordance with any of Claims 1 to 16, **characterized in that** the insert (E) has an electric socket (3) at the front, and **in that** the end plate is designed as attachment (A) and has an electric plug (10) interacting with the electric socket (3).

18. Electrical/electronic installation device in accordance with any of Claims 1 to 17, **characterized in that** the insert (E) has multiple channels, and **in that** the end plate (4) has a plurality of coupling elements designed as guideways (5) for interacting with at least two operating elements (1).

## Revendications

1. Appareil d'installation électrique/électronique avec un module fonctionnel réalisé sous forme d'insert (E), qui est prévu pour le montage dans une boîte d'installation (I) montée dans un mur de bâtiment (G), et qui présente des composants électriques/électroniques (K) nécessaires à la fonction et qui est pouvu à l'arrière d'éléments de liaison (8) pour le raccordement à un système d'installation d'un bâtiment et qui à l'avant présente des éléments de couplage pour établir une liaison active magnétique avec au moins un élément de commande (1), au moins un capteur (2) détectant des champs magnétiques variables étant logé dans l'insert (E) et l'élément de commande (1) présentant au moins un élément magnétique (9) qui coopère avec l'au moins un capteur (2) de l'insert (E) disposé de manière séparée galvaniquement,
l'insert (E) étant pourvu sur le côté frontal d'une plaque terminale (4) venant s'appliquer sur le côté arrière contre le mur de bâtiment (G), et
la plaque terminale (4) présentant sur sa surface extérieure tournée vers l'au moins un élément de commande (1) au moins un élément de couplage réalisé sous forme de piste de guidage (5), laquelle au moins une piste de guidage (5) est équipée de plusieurs éléments métalliques magnétiques (6), et
l'au moins un élément de commande (1) présentant au moins un dispositif de guidage coopérant avec l'au moins une piste de guidage (5), et
plusieurs éléments magnétiques (9), dont le nombre correspond aux éléments métalliques magnétiques (6) de la piste de guidage (5), étant associés à l'au moins un dispositif de guidage.

2. Appareil d'installation électrique/électronique selon la revendication 1, **caractérisé en ce qu'**au moins un dispositif de guidage est réalisé sous forme de rainure de guidage (7).

3. Appareil d'installation électrique/électronique selon l'une quelconque des revendications 1 ou 2, **caractérisé en ce que** les éléments métalliques magnétiques (6) sont répartis uniformément sur la dimension de la piste de guidage (5).

4. Appareil d'installation électrique/électronique selon l'une quelconque des revendications 1 à 3, **caractérisé en ce que** les éléments magnétiques (9) associés à l'au moins un dispositif de guidage en sont répartis uniformément sur sa dimension.

5. Appareil d'installation électrique/électronique selon l'une quelconque des revendications 1 à 4, **caractérisé en ce qu'**au moins l'un des éléments métalliques magnétiques (6) présente une forme cylindrique.

6. Appareil d'installation électrique/électronique selon l'une quelconque des revendications 1 à 5, **caractérisé en ce qu'**au moins l'un des éléments magnétiques (9) présente une forme cylindrique.

7. Appareil d'installation électrique/électronique selon l'une quelconque des revendications 1 à 6, **caractérisé en ce que** plusieurs premières poches de réception pour la fixation des éléments métalliques magnétiques (6) sont formés dans la piste de guidage (5).

8. Appareil d'installation électrique/électronique selon l'une quelconque des revendications 1 à 6, **caractérisé en ce que'**en association avec l'au moins un dispositif de guidage (rainure de guidage 7), plusieurs secondes poches de réception sont formées dans l'élément de commande (1) pour la fixation des éléments magnétiques (9).

9. Appareil d'installation électrique/électronique selon l'une quelconque des revendications 1 à 8, **caractérisé en ce que'**au moins un élément de commande (1) est réalisé de manière à pouvoir être tourné manuellement.

10. Appareil d'installation électrique/électronique selon l'une quelconque des revendications 1 à 9, **caractérisé en ce que'**au moins un élément de commande (1) est réalisé de manière à pouvoir être déplacé manuellement.

11. Appareil d'installation électrique/électronique selon l'une quelconque des revendications 1 à 10, **caractérisé en ce que'**au moins un élément de commande (1) est réalisé de manière à pouvoir être pivoté manuellement.

12. Appareil d'installation électrique/électronique selon l'une quelconque des revendications 1 à 11, **caractérisé en ce que'**au moins un élément de commande (1) est réalisé sous forme d'anneau d'actionnement.

13. Appareil d'installation électrique/électronique selon l'une quelconque des revendications 1 à 12, **caractérisé en ce que'**au moins un élément de commande (1) est réalisé sous forme d'un bouton de commande présentant une forme cylindrique.

14. Appareil d'installation électrique/électronique selon l'une quelconque des revendications 1 à 13, **caractérisé en ce que'**au moins un élément de commande (1) est réalisé sous forme d'un bouton de commande présentant au moins trois zones d'angle.

15. Appareil d'installation électrique/électronique selon l'une quelconque des revendications 1 à 14, **caractérisé en ce que'**au moins un élément de commande (1) est pourvu d'au moins une désignation de fonction.

16. Appareil d'installation électrique/électronique selon l'une quelconque des revendications 1 à 15, **caractérisé en ce que** la plaque terminale (4) est pourvue, sur sa face arrière associée au mur du bâtiment, d'un joint d'étanchéité venant en appui sur le mur du bâtiment.

17. Appareil d'installation électrique/électronique selon l'une quelconque des revendications 1 à 16, **caractérisé en ce que** l'insert (E) présente sur la face avant une prise femelle électrique (3), et **en ce que** la plaque terminale est réalisée sous forme de rehausse (A) et présente une fiche électrique (10) coopérant avec la prise femelle électrique (3).

18. Appareil d'installation électrique/électronique selon l'une quelconque des revendications 1 à 17, **caractérisé en ce que** l'insert (E) est réalisé en plusieurs canaux, et **en ce que** la plaque terminale (4) présente plusieurs éléments de couplage réalisés sous forme de pistes de guidage (5) pour coopérer avec au moins deux éléments de commande (1).
